# EUROPÄISCHE PATENTSCHRIFT

(11) **EP 1 673 488 B1**
(45) Veröffentlichungstag und Bekanntmachung des Hinweises auf die Patenterteilung: **07.10.2009**
(21) Anmeldenummer: 04790508.8
(22) Anmeldetag: 15.10.2004
(51) Int. Cl.: C23C 14/32, C23C 14/34, H01J 37/32

(54) **MODULARE VORRICHTUNG ZUR BESCHICHTUNG VON OBERFLÄCHEN**
MODULAR DEVICE FOR SURFACE COATING
DISPOSITIF MODULAIRE DE REVÊTEMENT DE SURFACES

(30) Priorität: 17.10.2003 EP 03405753
(43) Veröffentlichungstag der Anmeldung: 28.06.2006
(73) Patentinhaber: Platit AG, 2540 Grenchen (CH); Pivot a.s., 78701 Sumperk (CZ)
(72) Erfinder: CSELLE, Tibor, CH-2540 Grenchen (CH); JILEK, Mojmir, 787 01 Sumperk (CZ)
(74) Vertreter: EGLI-EUROPEAN PATENT ATTORNEYS
(86) Internationale Anmeldenummer: PCT/EP2004/011669
(87) Internationale Veröffentlichungsnummer: WO 2005/038077

(56) Entgegenhaltungen:
- WO-A-02/50864
- WO-A-02/50864
- WO-A-90/02216
- WO-A-90/02216
- DE-A- 4 443 740
- DE-A- 4 443 740
- DE-A1- 3 829 260
- US-A- 5 750 207
- US-A- 5 750 207
- US-A1- 2002 140 334
- US-A1- 2002 182 448
- US-A1- 2002 182 448
- US-A1- 2003 035 894
- CSELLE T: "LARC: NEUE, INDUSTRIELLE BESCHICHTUNGSTECHNOLOGIE" WERKSTATT UND BETRIEB, CARL HANSER VERLAG, MUNCHEN, DE, Bd. 136, Nr. 3, März 2003 (2003-03), Seiten 12,14-17, XP001145166 ISSN: 0043-2792

## Beschreibung

Die vorliegende Erfindung betrifft eine modulare Vorrichtung zur Beschichtung von Oberflächen von Gegenständen (Substraten) durch das physikalische Aufbringen von Material im Vakuum (PVD) mit Hilfe eines Lichtbogens oder mehreren Lichtbögen, einschliesslich der Beschichtung mit mehreren Schichten auf unterschiedlicher Weise, die im folgenden modulare, dedizierte Beschichtung genannt wird. Des weiteren betrifft die Erfindung ein System mit einer solchen modularen Vorrichtung.

Schon aus der WO-A-02/50865 ist eine Vorrichtung bekannt, durch die eine Beschichtung auf einem Werkstück durch das Abscheiden von typischerweise zwei in etwa zylindrischen Targets bewirkt wird, wobei dann das Material auf dem Werkstück niederschlägt und so eine Schicht ausbildet. In der WO-A-02/50865 wird dazu vorgeschlagen, das Target durch eine bestimmte Magnetfeldanordnung so auszubilden, dass ein gerichtetes Materialabdampfen stattfinden kann und so bestimmte Effekte erzielt werden können.

Aus der EP-A-1357577 ist ein Verfahren dazu bekannt, optimale Effekte der selektiven Beschichtung durchzuführen.

In der Beschichtungskammer sind dabei ein oder mehrere, im wesentlichen zylinderförmig ausgebildete Kathoden angeordnet und mit Hilfe von Magnetquellen wird die Abscheidung des Materials gesteuert. Die Magnetquellen sind dabei vorzugsweise in den Kathoden angeordnet und die Kathode wird gegenüber der Magnetfeldquelle oder die Magnetfeldquelle gegenüber der Kathode verdreht, um so ein gleichmässiges Abtragen des Materials vom Target zu bewirken. Dieses Material wird dann auf den Substraten abgeschieden.

In einer solchen Kammer werden dabei üblicherweise Substrate auf einem Drehteller platziert und - unter Drehung des Tellers - sukzessive beschichtet. Nach dem Stand der Technik ist es bekannt, die Kathode z.B. in die Mitte des Drehtellers zu platzieren, um so eine Beschichtung von mehreren Gegenständen in einer Kammer durchführen zu können.

Eine Anordnung nach der WO-A-02/50865 kann als erfolgreiche Vorrichtung angesehen werden, wenn in etwa stabförmige Gegenstände beschichtet werden sollen. Für diesen Fall wird man eine entsprechende Beschichtungskammer auswählen. Es hat sich aber herausgestellt, dass eine Beschichtungskammer, die für eine Vielfalt von zu beschichtenden Gegenständen geeignet sein soll, vielseitiger sein muss.

Aus WO 90/02216 A ist eine Vorrichtung zum Beschichten mittels eines PVD-Verfahrens in einer Vakuumkammer bekannt. Zur Erzeugung von Lichtbögen dienen in diesem Fall mehrere Kathoden, die als rechteckige, längliche Platten ausgebildet sind und die derart angeordnet sind, dass ihre Längsrichtungen jeweils vertikal ausgerichtet sind. Ein Teil der Kathoden sind am Rand der Vakuumkammer an einer vertikalen Tür der Vakuumkammer angeordnet, andere Kathoden sind im Wesentlichen in der Mitte der Vakuumkammer angeordnet. Die zu beschichtenden Gegenstände können auf einem Drehtisch platziert werden, welcher es ermöglicht, die jeweiligen Gegenstände an den am Rand der Vakuumkammer bzw. den in der Mitte der Vakuumkammer angeordneten Kathoden vorbeizubewegen.

In US 5750207 ist eine Vorrichtung zum Beschichten mittels eines PVD-Verfahrens in einer Vakuumkammer offenbart. Zum Erzeugen eines Lichtbogens dienen in diesem Fall ebenfalls rechteckige, längliche Platten, deren Längsrichtungen jeweils vertikal ausgerichtet sind. Mehrere Kathoden sind jeweils an Türen in einer Wand der Vakuumkammer befestigt, mehrere Kathoden sind im Zentrum der Vakuumkammer angeordnet.

Aus dem Artikel "LARC: Neue, industrielle Beschichtungstechnologie", aus "Werkstatt und Betrieb", Carl Hanser Verlag, Band 136, Nr. 3, März 2003, Seiten 12-17, ist eine Vorrichtung zum Beschichten mittels eines PVD-Verfahrens in einer Vakuumkammer offenbart, wobei zur Erzeugung von Lichtbögen rotierende, zylindrisch ausgebildete Kathoden dienen, die an einer Wand der Vakuumkammer angeordnet sind und deren Längsachsen jeweils vertikal ausgerichtet sind.

Aus DE 44 43 740 A1 ist eine weitere Vorrichtung zum Beschichten in einer Vakuumkammer mit mehreren, sich über die Höhe der Kammer erstreckende, vertikal angeordnete Verdampferquellen in Form von Magnetfeld-Kathoden bekannt, welche Verdampferquellen um einen horizontal angeordneten Drehteller für Substrate angeordnet sind. Zusätzlich können Verdampferquellen von aussen her abnehmbar in der Kammerwand gehaltert werden.

In US 2002/0182448 ist eine Vorrichtung zum Beschichten in einer Vakuumkammer beschrieben, die eine Vakummkammer mit zwei aufklappbaren Türen aufweist, in denen je zwei Kathoden angeordnet sind; weiter auch eine Vorrichtung, welche vier vertikal ausgerichtete, an jeweils einer Tür der Vakuumkammer befestigte und um einen Drehtisch für Substrate angeordnete Kathoden aufweist.

Es ist also zunächst einmal die Aufgabe der Erfindung, eine variable Beschichtungskammer bzw. eine variable Anordnung von Beschichtungsmitteln anzugeben, die für auch andere zu beschichtende Gegenstände geeignet und damit variabler ist, als nach dem vorbekannten Stand der Technik. Insbesondere soll eine homogene Beschichtung flacher Gegenstände grosser Durchmesser ermöglicht werden.

Die Erfindung löst die Aufgabe durch eine Anordnung nach Anspruch 1. Dabei haben die Massnahmen der Erfindung zunächst einmal zur Folge, dass durch die modulare Anordnung eine Vielzahl von Beschichtungssituationen behandelt werden kann.

Die Anordnung dient zur Aufnahme in ein Beschichtungssystem.

Vorteilhafte Ausgestaltungen der Erfindung sind in den abhängigen Ansprüchen angegeben.

Die vorgenannten sowie die beanspruchten und in den nachfolgenden Ausführungsbeispielen beschriebenen, erfindungsgemäss zu verwendenden Verfahrenschritte und die dazugehörigen Elemente unterliegen in ihrer Grösse, Formgestaltung, Materialverwendung und technischen Konzeption keinen besonderen Ausnahmebedingungen, so dass die in dem jeweiligen Anwendungsgebiet bekannten Auswahlkriterien uneingeschränkt Anwendung finden können.

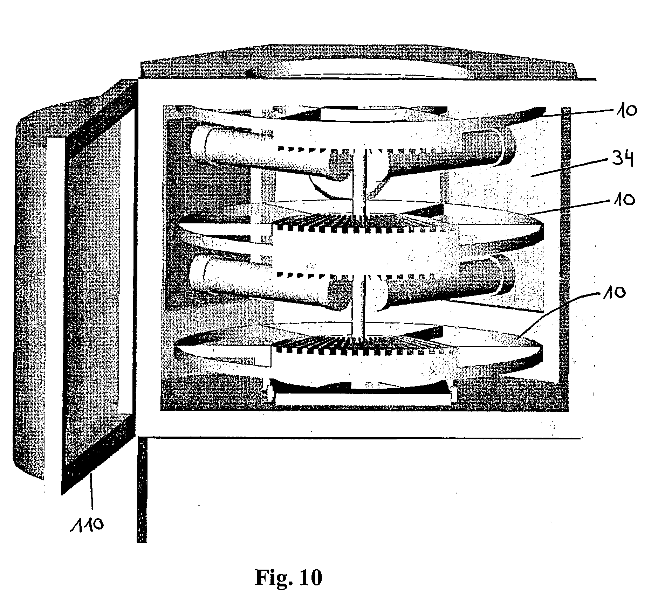

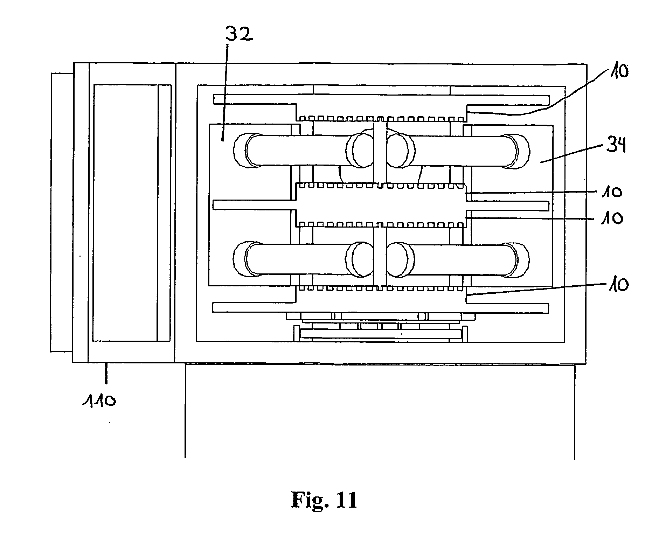

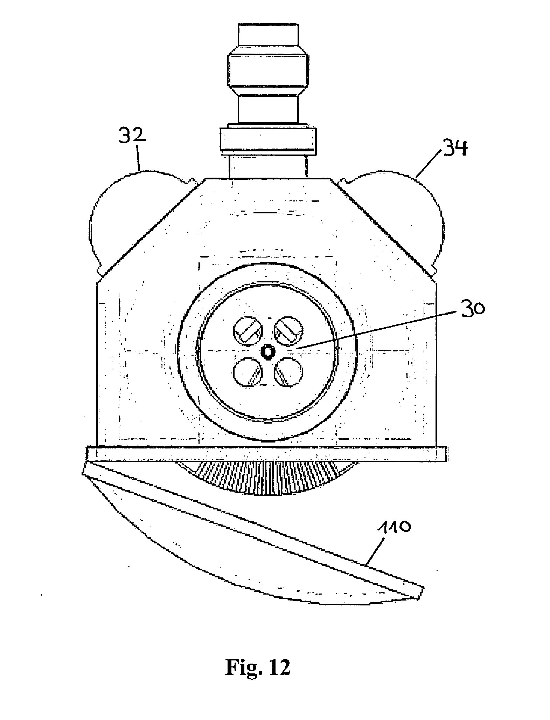

Weitere Einzelheiten, Merkmale und Vorteile des Gegenstandes der Erfindung ergeben sich aus der nachfolgenden Beschreibung der dazugehörigen Zeichnungen, wobei in den Figuren 10-12 - bei- spielhaft - eine modulare Vorrichtung gemäss der vorliegenden Erfindung erläutert wird.

In den Zeichnungen zeigen:
- Figur 1: eine perspektivische Darstellung einer Beschichtungskammer, in der die Anordnung gemäss der vorliegenden Erfindung realisiert ist;
- Figur 2: ebenfalls eine perspektivische Darstellung des Gegenstandes nach Figur 1;
- Figur 3: eine erste Konfiguration einer modularen Anordnung in perspektivischer Darstellung, die nicht Gegenstand der Erfindung ist.
- Figur 4: eine zweite Konfiguration der modularen Anordnung in perspektivischer Darstellung;
- Figur 5: die Konfiguration nach Figur 4 von oben;
- Figur 6: eine dritte Konfiguration der modularen Anordnung in perspektivischer Darstellung;
- Figur 7: die Konfiguration nach Figur 6 von oben;
- Figur 8: eine vierte Konfiguration der modularen Anordnung in Darstellung von oben;
- Figur 9: eine fünfte Konfiguration der modularen Anordnung in Darstellung von oben;
- Figur 10: eine erfindungsgemässe Konfiguration mit horizontalen Kathoden (sechste Konfiguration) in perspektivischer Darstellung;
- Figur 11: die Konfiguration mit horizontalen Kathoden nach Figur 10 von der Seite;
- Figur 12: die Konfiguration mit horizontalen Kathoden nach Figur 10 von oben;
- Figur 13: eine Konfiguration gemäss Figur 1, aber mit einer planaren Kathode, (siebte Konfiguration) in perspektivischer Darstellung;
- Figur 14: die Konfiguration nach Figur 13 von der Seite;
- Figur 15: eine weitere Kathodenanordnung.

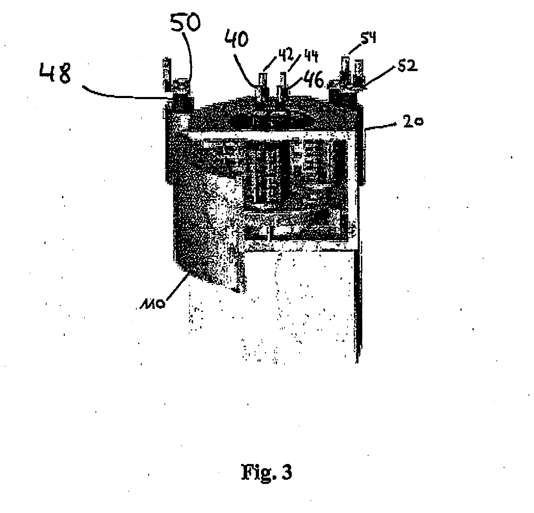

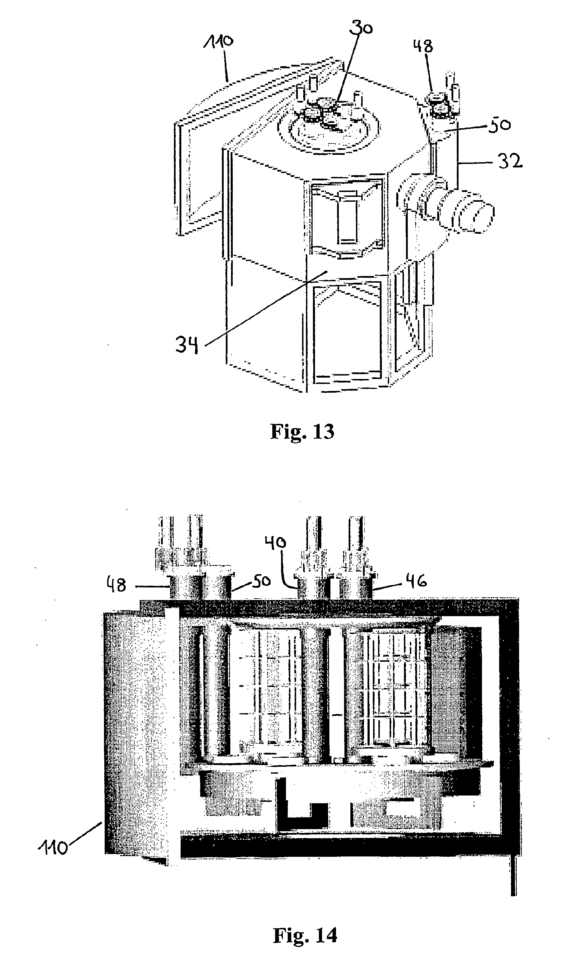

Die Figuren 3-9 und 13-15 zeigen Kathodenanordnungen, welche nicht Gegenstand der beanspruchten Erfindung sind.

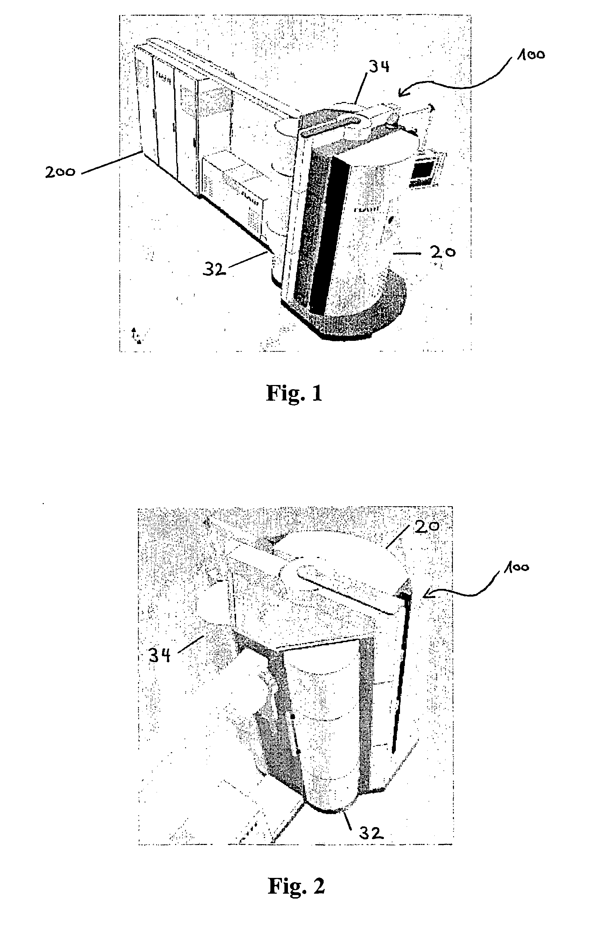

In Figur 1 ist eine Beschichtungsanlage als Gesamtsystem 100 mit der dazu gehörenden Elektronik 200 dargestellt. Das Kernstück des Systems ist die Beschichtungskammer, die - wie insbesondere aus Figur 2 ersichtlich - zwei oder mehrere türartige Einrichtungen 32, 34 an den Seiten aufweist. In diesen Einrichtungen können Kathoden - zusätzlich zu den bereits aus dem Stand der Technik bekannten, innenliegenden Aufnahmeeinrichtungen für Kathoden - aufgenommen werden und zwar in sehr unterschiedlichen Konfigurationen, von denen einige prinzipiell im nachfolgenden beschrieben werden.

Als erste Konfiguration gibt Figur 3 die Vollkonfiguration für eine modulare Anordnung wieder. In der Kammer 100 mit einer Zugangstür 110 ist mittig eine Anordnung mit 4 Rotationskathoden 40, 42, 44, 46 ausgebildet. Weiterhin sind an den beschriebenen türartigen Einrichtungen 32, 34 an den Seiten jeweils zwei weitere Kathoden 48, 50, 52 und 54 untergebracht. Um die mittig angeordneten Kathoden herum ist ein drehtellerartiger Substrathalter angeordnet, auf dem eine Vielzahl von Substraten untergebracht ist. Bei der Beschichtung in dieser Konfiguration sind - aber nicht zwangsläufig - alle Kathoden allenfalls aus dem gleichen Material. In dieser Konfiguration wird dann die höchste Abscheidungsrate bzw. die grösste Beschichtungsrate erzielt.

Es sollte nur der Vollständigkeit halber darauf hingewiesen werden, dass die Rotationskathoden vorzugsweise in der Art betrieben werden, wie sie in dem zitierten Stand der Technik vorgeschlagen wurde, also mit einer Einrichtung zur gerichteten Ausbildung von Lichtbögen.

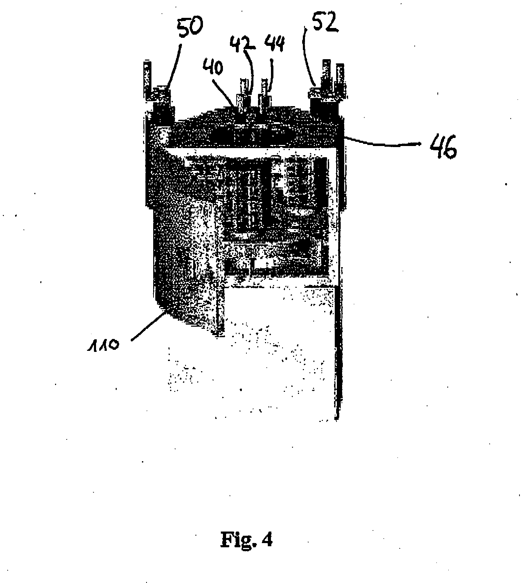

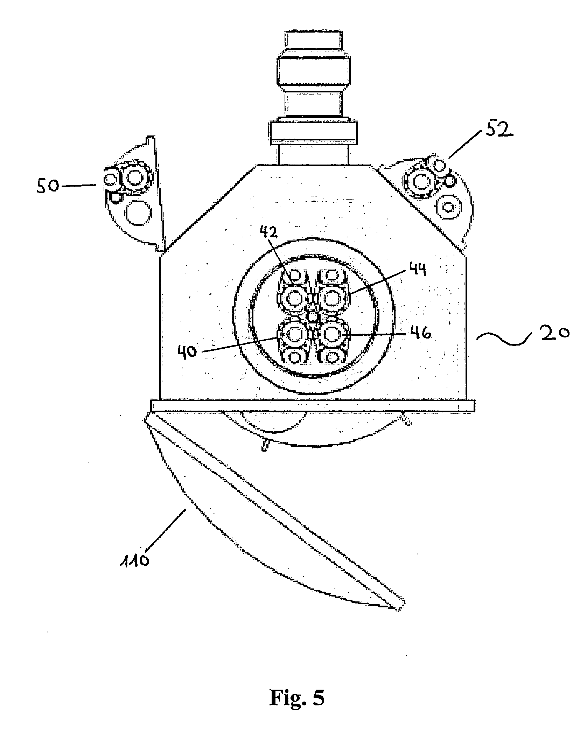

Die zweite Konfiguration gemäss Fig. 4 und 5 unterscheidet sich von der vorstehend beschriebenen ersten, auf den ersten Blick nur dadurch, dass neben den vier Kathoden 40, 42, 44 und 46 - wie gehabt - im Innenbereich jede der beiden Aussenstationen 32 und 34 nur mit jeweils einer Kathode 50 und 52 bestückt sind. Bei dieser Konfiguration werden mit einer hohen Abscheidrate im Innenbereich die Aussenkathoden 50 und 52 für spezialaufgaben, z.B. zum Ionenätzen oder zum Abscheiden von Alternativschichten, verwendet. Solche Alternativschichten können Diamantbeschichtungen sein oder aber z.B. Schmierschichten. Es sollte betont werden, dass die Aussenkathoden gleichzeitig oder auch zeitlich getrennt von den Innenkathoden - oder auch zueinander - betrieben werden können, je nach der speziellen Beschichtungsaufgabe.

Die anderen Merkmale der zweiten Konfiguration entsprechen der ersten.

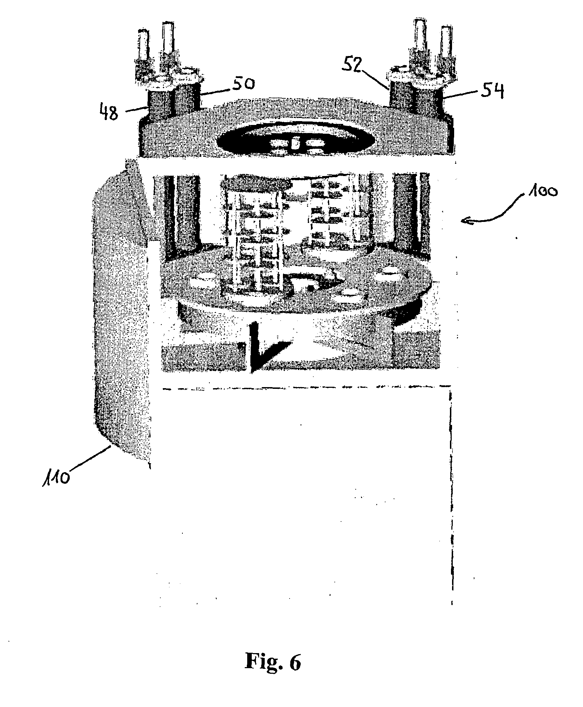

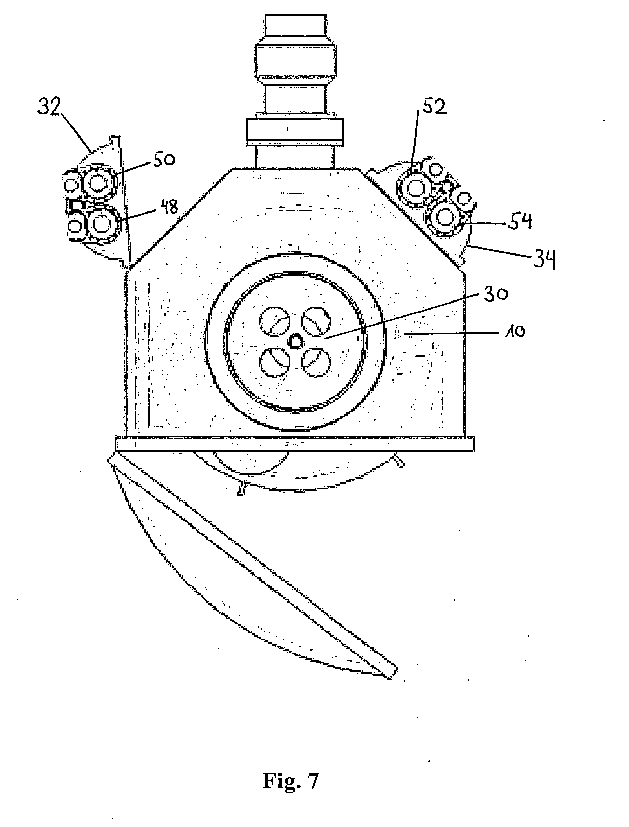

In der dritten Konfiguration gemäss Fig. 6 und 7 werden nur die beiden Aussenstationen 32 und 34 - jeweils mit zwei Kathoden - bestückt, um z.B. grosse Teile 10 (Gesenke oder Kreissägeblätter etc.) von aussen beschichten zu können. Die Innenstation 30 bleibt in dieser Konfiguration frei. Die anderen Merkmale der dritten Konfiguration entsprechen der zweiten.

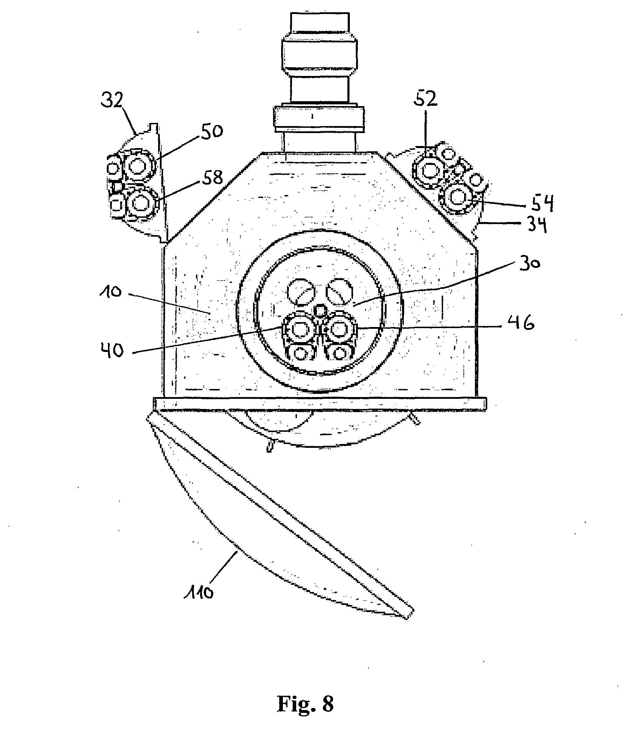

Die vierte Konfiguration gemäss Fig. 8 unterscheidet sich von der vorstehend beschriebenen ersten dadurch, dass neben den 4 Kathoden 48, 50, 52 und 54 im Aussenbereich auf der Innenstation 30 nur zwei Kathoden vorgesehen sind, nämlich die den Aussenstationen entfernt angeordneten Kathoden 40 und 46. Bei dieser Konfiguration wird die Beeinflussung der Plasmen zwischen den Kathoden der Aussenstationen 32 und 34 und denen der Innenstation 30 ausgeschlossen.

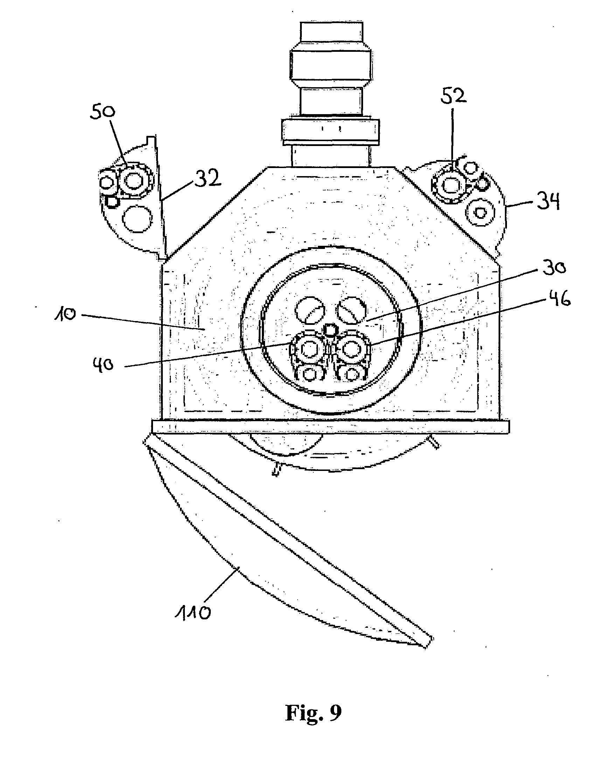

Die fünfte Konfiguration gemäss Fig. 9 unterscheidet sich von der vorstehend beschriebenen ersten dadurch, dass nur zwei Kathoden 48 und 52 im Aussenbereich und auf der Innenstation 30 auch nur zwei Kathoden vorgesehen sind, nämlich die den Aussenstationen entfernt angeordneten Kathoden 40 und 46. Dies ist eine weitere typische Konfiguration für eine Alternativbeschichtung, wobei wiederum die Kathoden der Aussenstationen und der Innenstation typischerweise unterschiedliche Materialien aufweisen.

Überraschenderweise hat sich herausgestellt, dass die erfindungsgemässe Konfiguration gemäss den Fig. 10 bis 12 besonders gut mit der modularen Anordnung hergestellt und betrieben werden kann. In dieser Konfiguration sind die beiden Aussenstationen 32 und 34 mit jeweils zwei horizontal angeordneten Rotationskathoden bestückt. In diesem Falle werden horizontale Wirkflächen ausgebildet, wie sie z.B. für Bandsägen und andere flache Gegenstände nützlich sind. In der vorliegenden Konfiguration werden mit den jeweils zwei Kathoden insgesamt vier Flächen beschichtet, wie in Fig. 10 dargestellt ist. Der besondere Vorteil dieser Konfiguration ist es, dass grosse Durchmesser beladbar sind und eine homogene Beschichtung an der Wirkfläche, z.B. die Freifläche von Bandsägen oder die Stirnfläche von Umformwerkzeugen in Form von Stempel und Matrizen Mold and dies, ohne schädliche Schichtdickenunterschiede ermöglicht werden.

Die siebte Konfiguration gemäss Fig'. 13 und 14 unterscheidet sich von der vorstehend beschriebenen ersten dadurch, dass neben den vier Kathoden 40, 42, 44 und 46 - wie gehabt - im Innenbereich nur eine Aussenstation 32 mit zwei Rotationskathoden 48 und 50 bestückt ist. Die andere Aussenstatiön 34 ist mit einer oder mehreren herkömmlichen, planaren Kathode bestückt.

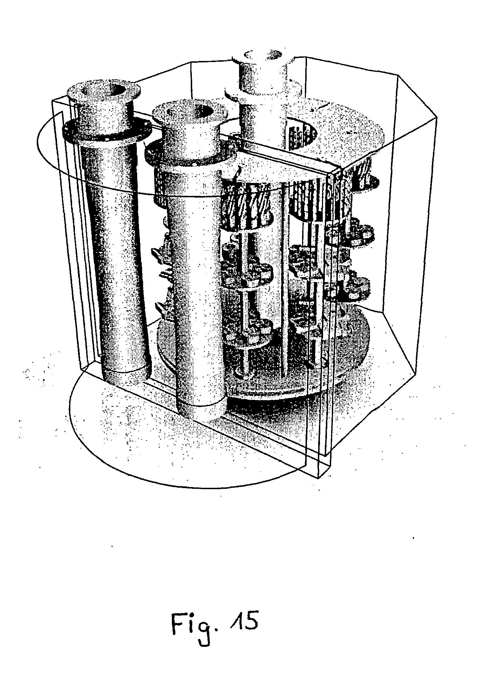

In Figur 15 ist eine Kathodenanordnung dargestellt.

Der Fachmann wird erkennen, dass die vorstehend beschriebenen Konfigurationen gemäss Fig. 10-12 nicht abschliessend sind, sondern nur beispielhaft innerhalb des Bereichs der nachstehenden Patentansprüche dem Fachmann Ausführungen an die Hand geben.

## Patentansprüche

1. Modulare Vorrichtung zum Beschichten von Gegenständen (10),
mit einer Vakuumkammer (20), in der ein physikalisches Abscheideverfahren durchgeführt werden kann,
wobei die Vakuumkammer (20) zumindest ein Anodenmittel sowie eine Vielzahl von Aufnahmeeinrichtungen für Kathoden (40, 42, 44, 46, 48, 50, 52, 54) umfasst, wobei mehrere Lichtbögen zwischen dem zumindest einen Anodenmittel und den Kathoden (40, 42, 44, 46, 48, 50, 52, 54) gezündet werden können;
mit einer ersten Aufnahmeeinrichtung (30) zur Aufnahme von zumindest einer Kathode (40, 42, 44, 46) im wesentlichen in der Mitte der Vakuumkammer (20) und
mit einer zweiten Aufnahmeeinrichtung (32, 34) zur Aufnahme von zumindest einer Kathode (48, 50, 52, 54) am Rand der Vakuumkammer (20), wobei die zweite Aufnahmeeinrichtung (32, 34) oder die zweiten Aufnahmeeinrichtungen (32, 34) als abnehmbare und/oder aufklappbare Türen für die Vakuumkammer (20) ausgebildet sind,
**dadurch gekennzeichnet, dass**
mehrere in etwa zylinderförmig ausgebildete Kathoden in die zweite Aufnahmeeinrichtung (32, 34) oder die zweiten Aufnahmeeinrichtungen (32, 34) am Rand der Vakuumkammer (20) aufgenommen sind, welche Kathoden im Wesentlichen horizontal und im Wesentlichen übereinander angeordnet sind und in die Vakuumkammer hineinragen.

2. Modulare Vorrichtung nach Anspruch 1, **dadurch gekennzeichnet, dass** zwei zweite Aufnahmeeinrichtungen (32, 34) zur Aufnahme von jeweils zumindest zwei Kathoden (48, 50, 52, 54) am Rand der Vakuumkammer (20) als abnehmbare und/oder aufklappbare Türen für die Vakuumkammer (20) ausgebildet sind.

3. Modulare Vorrichtung nach einem der vorstehenden Ansprüche, mit einem Substratanordnungsmittel zur Aufnahme von einem oder mehreren zu beschichtenden Gegenständen (10).

4. Modulare Vorrichtung nach einem der vorstehenden Ansprüche, wobei die Vakuumkammer (20) als das Anodenmittel ausgebildet ist.

5. Modulare Vorrichtung nach Anspruch 3, wobei das Substratanordnungsmittel als Drehkarussell ausgebildet ist und das Drehkarussell um die erste Aufnahmeeinrichtung (30) herum ausgebildet ist.

6. Modulare Vorrichtung nach Anspruch 5, **dadurch gekennzeichnet, dass** das Drehkarussell so ausgebildet ist, dass auf dem Drehkarussell Drehwagen zur Aufnahme von zu beschichtenden Gegenständen (10) und/oder zur Aufnahme von Satelliten zur Aufnahme von zu beschichtenden Gegenständen (10) angeordnet sind.

## Claims

1. A modular device for coating objects (10),
comprising a vacuum chamber (20), in which a physical deposition method can be carried out, wherein the vacuum chamber (20) comprises at least one anode means as well as a plurality of receiving devices for cathodes (40, 42, 44, 46, 48, 50, 52, 54), wherein several electric arcs can be ignited between the at least one anode means and the cathodes (40, 42, 44, 46, 48, 50, 52, 54);
comprising a first receiving device (30) for receiving at least one cathode (40, 42, 44, 46) substantially in the center of the vacuum chamber (20) and comprising a second receiving device (32, 34) for receiving at least one cathode (48, 50, 52, 54) at the edge of the vacuum chamber (20), wherein the second receiving device (32, 34) or the second receiving devices (32, 34) are embodied as detachable and/or swivelable doors for the vacuum chamber (20),
**characterized in that**
several cathodes, which are embodied in an approximately cylindrical manner, are received into the second receiving device (32, 34) or the second receiving devices (32, 34) are received at the edge of the vacuum chamber (20), said cathodes being arranged substantially horizontally and substantially on top of one another and extend into the vacuum chamber.

2. The modular device according to claim 1, **characterized in that** two second receiving devices (32, 34) for receiving at least two cathodes (48, 50, 52, 54) in each case are embodied at the edge of the vacuum chamber (20) as detachable and/or swivelable doors for the vacuum chamber (20).

3. The modular device according to one of the preceding claims comprising a substrate configuration means for receiving one or several objects (10), which are to be coated.

4. The modular device according to one of the preceding claims, wherein the vacuum chamber (20) is embodied as the anode means.

5. The modular device according to claim 3, wherein the substrate configuration means is embodied as a rotating carousel and the rotating carousel is embodied around the first receiving device (30).

6. The modular device according to claim 5, **characterized in that** the rotating carousel is embodied in such a manner that rotating carriages for receiving objects (10), which are to be coated, and/or for receiving satellites for receiving objects (10), which are to be coated, are arranged on the rotating carousel.

## Revendications

1. Dispositif modulaire pour l'enduction d'objets (10),
comprenant une chambre à vide (20), dans laquelle un procédé de séparation physique peut être mis en oeuvre,
la chambre à vide (20) comprenant au moins un moyen d'anode ainsi qu'une pluralité de dispositifs de réception pour des cathodes (40, 42, 44, 46, 48, 50, 52, 54), plusieurs arcs électriques pouvant être allumés entre le au moins un moyen d'anode et les cathodes (40, 42, 44, 46, 48, 50, 52, 54),
un premier dispositif de logement (30) pour le logement d'au moins une cathode (40, 42, 44, 46) essentiellement au centre de la chambre à vide (20) et un second dispositif de logement (32, 34) pour le logement d'au moins une cathode (48, 50, 52, 54) sur le bord de la chambre à vide (20), le second dispositif de logement (32, 34) ou les seconds dispositifs de logement (32, 34) étant conçus sous forme de portes amovibles et/ou repliables pour la chambre à vide (20),
**caractérisé en ce que**
plusieurs cathodes conçues dans une forme à peu près cylindrique sont réceptionnées dans le second dispositif de logement (32, 34) ou les seconds dispositifs de logement (32, 34) en bordure de la chambre à vide (20), lesquelles cathodes sont disposées essentiellement horizontalement et essentiellement les unes au-dessus des autres et dépassent dans la chambre à vide.

2. Dispositif modulaire selon la revendication 1,
**caractérisé en ce que** deux seconds dispositifs de logement (32, 34) pour le logement de respectivement au moins deux cathodes (48, 50, 52, 54) en bordure de la chambre à vide (20) sont conçus sous forme de portes amovibles et/ou repliables pour la chambre à vide (20).

3. Dispositif modulaire selon l'une quelconque des revendications précédentes, comprenant un moyen d'agencement de substrat pour le logement d'un ou plusieurs objets (10) à enduire.

4. Dispositif modulaire selon l'une quelconque des revendications précédentes, la chambre à vide (20) étant conçu en tant que moyen d'anode.

5. Dispositif modulaire selon la revendication 3, le moyen d'agencement de substrat étant conçu comme carrousel tournant et le carrousel tournant étant réalisé autour du premier dispositif de logement (30).

6. Dispositif modulaire selon la revendication 5,
**caractérisé en ce que** le carrousel tournant est conçu de telle sorte que des chariots tournants sont disposés sur le carrousel tournant pour le logement d'objets (10) à enduire et/ou pour le logement de satellites pour le logement d'objets (10) à enduire.
